# EUROPEAN PATENT APPLICATION

(11) **EP 2 261 997 A1**
(43) Date of publication of application: **15.12.2010**
(21) Application number: 10160250.6
(22) Date of filing: 19.04.2010
(51) Int. Cl.: H01L 31/0368, H01L 31/0376, H01L 31/075, H01L 31/20

(54) **Photovoltaic device and manufacturing method thereof**

(30) Priority: 12.06.2009 KR 20090052234
(71) Applicant: KISCO, Changwon-si Gyeongsangnam-do 641-370 (KR)
(72) Inventor: Myong, Seung-Yeop, 156-831, Seoul (KR)
(74) Representative: Zardi, Marco

(57) **Abstract**

Disclosed is a photovoltaic device. The photovoltaic device includes:
a substrate;
a first electrode disposed on the substrate;
a plurality of photoelectric transformation layers disposed on the first electrode, the photoelectric transformation layer comprising a light absorbing layer; and
a second electrode disposed on a plurality of the photoelectric transformation layers;
wherein the light absorbing layer comprised in at least one of a plurality of the photoelectric transformation layers comprises a first sub-layer and a second sub-layer, each of which comprises hydrogenated amorphous silicon and hydrogenated proto-crystalline silicon respectively, and
wherein a thickness of the first sub-layer is actually the same as a thickness of the second sub-layer.

## Description

This application claims the benefit of Korean Patent Application No. 10-2009-0052234 filed on June 12, 2009, which is hereby incorporated by reference.

### BACKGROUND

### Field

This application relates to a photovoltaic device and a manufacturing method thereof.

### Description of the Related Art

Recently, as existing energy sources such as oil and charcoal and so on are expected to be exhausted, attention is now paid to alternative energy sources which can be used in place of the existing energy sources. Among the alternative energy sources, sunlight energy is abundant and has no environmental pollution. For this reason, more and more attention is paid to the sunlight energy.

A photovoltaic device, that is to say, a solar cell converts directly sunlight energy into electrical energy. The photovoltaic device uses mainly photovoltaic effect of semiconductor junction. In other words, when light is incident and absorbed to a semiconductor pin junction formed through a doping process by means of p-type and n-type impurities respectively, light energy generates electrons and holes at the inside of the semiconductor. Then, the electrons and the holes are separated by an internal field so that a photo-electro motive force is generated at both ends of the pin junction. Here, if electrodes are formed at the both ends of junction and connected with wires, an electric current flows externally through the electrodes and the wires.

In order that the existing energy sources such as oil is substituted with the sunlight energy source, it is required that a degradation rate of the photovoltaic device should be low and a stability efficiency of the photovoltaic device should be high, which are produced by the elapse of time.

### SUMMARY

One aspect of this invention includes a photovoltaic device. The photovoltaic device includes:
a substrate;
a first electrode disposed on the substrate;
a plurality of photoelectric transformation layers disposed on the first electrode, the photoelectric transformation layer including a light absorbing layer; and
a second electrode disposed on a plurality of the photoelectric transformation layers;
wherein the light absorbing layer included in at least one of a plurality of the photoelectric transformation layers includes a first sub-layer and a second sub-layer, each of which includes hydrogenated amorphous silicon and hydrogenated proto-crystalline silicon respectively, and
wherein a thickness of the first sub-layer is actually the same as a thickness of the second sub-layer.

One aspect of this invention includes a method of manufacturing a photovoltaic device. The method includes:
forming a first electrode on a substrate;
forming at least one photoelectric transformation layer on the first electrode in a chamber, the photoelectric transformation layer including a light absorbing layer;
forming a second electrode on the photoelectric transformation layer;
wherein silane and hydrogen with a certain flow rate are supplied to the chamber while the light absorbing layer is formed, and
wherein a flow rate of the silane varies alternately within a range between a first flow rate value α and a second flow rate value β in accordance with the elapse of a deposition time T, and
   wherein the first flow rate value α and the second flow rate value β are reduced in accordance with the elapse of the deposition time T.

Another aspect of this invention includes a method of manufacturing a photovoltaic device. The method includes:
forming a first electrode on a substrate;
forming at least one photoelectric transformation layer on the first electrode in a chamber, the photoelectric transformation layer including a light absorbing layer;
forming a second electrode on the photoelectric transformation layer;
wherein silane and hydrogen with a certain flow rate are supplied to the chamber while the light absorbing layer is formed, and
   wherein a flow rate of the silane varies alternately within a range between a first flow rate value and a second flow rate value in accordance with the elapse of a deposition time T, and
   wherein a duration time of the first flow rate value and a duration time of the second flow rate value are reduced in accordance with the elapse of the deposition time T.

Further another aspect of this invention includes a method of manufacturing a photovoltaic device. The method includes:
forming a first electrode on a substrate;
forming at least one photoelectric transformation layer on the first electrode in a chamber, the photoelectric transformation layer including a light absorbing layer;
forming a second electrode on the photoelectric transformation layer;
wherein silane and hydrogen with a certain flow rate are supplied to the chamber while the light absorbing layer is formed, and
   wherein a flow rate of the silane varies alternately within a range between a first flow rate value α and a second flow rate value β in accordance with the elapse of a deposition time T, and
   wherein a duration time t1 of the first flow rate value α and a duration time t2 of the second flow rate value β are reduced in accordance with the elapse of the deposition time T, and
   wherein the first flow rate value α and the second flow rate value β are reduced in accordance with the elapse of the deposition time T.

### BRIEF DESCRIPTION OF THE DRAWINGS

The embodiment will be described in detail with reference to the following drawings.

Fig. 1 shows a photovoltaic device according to a first embodiment of the present invention.

Fig. 2 shows another photovoltaic device according to a second embodiment of the present invention.

Figs. 3A to 3H show a manufacturing method of a photovoltaic device according to an embodiment of the present invention.

Fig. 4 shows a plasma-enhanced chemical vapor deposition apparatus for forming a light absorbing layer according to an embodiment of the present invention.

Fig. 5 shows a variation of flow rate of source gas for forming a light absorbing layer according to an embodiment of the present invention.

Fig. 6 shows another variation of flow rate of source gas for forming a light absorbing layer according to an embodiment of the present invention.

Fig. 7 shows further another variation of flow rate of source gas for forming a light absorbing layer according to an embodiment of the present invention.

Fig. 8 shows a light absorbing layer including a plurality of sub-layers included in an embodiment of the present invention.

Fig. 9 shows a light absorbing layer consisting of a proto-crystalline silicon layer.

### DETAILED DESCRIPTION OF EMBODIMENTS

Embodiments will be described in a more detailed manner with reference to the drawings.

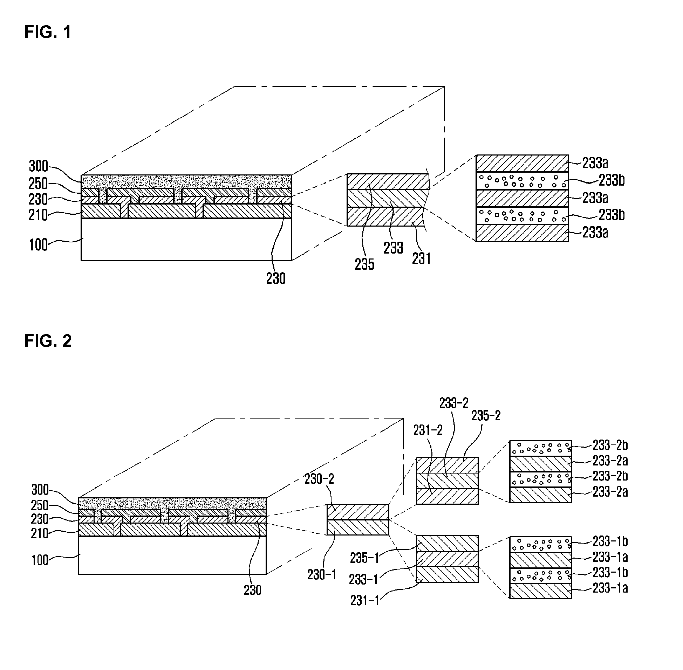

Fig. 1 shows a photovoltaic device according to a first embodiment of the present invention.

As shown, a photovoltaic device includes a substrate 100, a first electrode 210, a second electrode 250, a photoelectric transformation layer 230 and a protecting layer 300.

In detail, the first electrodes 210 are disposed on the substrate 100. The first electrodes 210 are spaced from each other at a regular interval in such a manner that adjacent first electrodes are not electrically short-circuited. The photoelectric transformation layer 230 is disposed on the first electrode 210 in such a manner as to cover the area spaced between the first electrodes at a regular interval. The second electrodes 250 are disposed on the photoelectric transformation layer 230 and spaced from each other at a regular interval in such a manner that adjacent second electrodes are not electrically short-circuited. In this case, the second electrode 250 penetrates the photoelectric transformation layer and is electrically connected to the first electrode 210 such that the second electrode 250 is connected in series to the first electrode 210. The adjacent photoelectric transformation layers 230 are spaced at the same interval as the interval between the second electrodes. The protecting layer 300 is disposed on the second electrode in such a manner as to cover the area spaced between the second electrodes and the area spaced between the photoelectric transformation layers.

The photoelectric transformation layer 230 includes a p-type semiconductor layer 231, a light absorbing layer 233 and an n-type semiconductor layer 235. The light absorbing layer 233 includes a first sub-layer 233A and a second sub-layer 233B stacked on the first sub-layer 233A. The first sub-layer 233A includes a hydrogenated amorphous silicon based material and the second sub-layer 233B includes a crystalline silicon grain.

Fig. 2 shows another photovoltaic device according to a second embodiment of the present invention.

Since a photovoltaic device of Fig. 2 is almost similar to that of Fig.1, descriptions of the same structure will be omitted. In Fig. 2, the photoelectric transformation layer 230 includes a first photoelectric transformation layer 230-1 and a second photoelectric transformation layer 230-2 disposed on the first photoelectric transformation layer. The first photoelectric transformation layer and the second photoelectric transformation layer include p-type semiconductor layers 231-1 and 231-2, light absorbing layers 233-1 and 233-2 and n-type semiconductor layers 235-1 and 235-2.

The light absorbing layers 233-1 and 233-2 include first sub-layers 233-1A and 233-2A and second sub-layers 233-1B and 233-2B stacked on the first sub-layers. Here, the light absorbing layer 233-1 included in the first photoelectric transformation layer 230-1 includes the first sub-layer 233-1A and the second sub-layer 233-1B. The first sub-layer 233-1A includes the hydrogenated amorphous silicon based material and the second sub-layer 233-1B includes a crystalline silicon grain. The light absorbing layer 233-2 included in the second photoelectric transformation layer 230-2 includes the first sub-layer 233-2A and the second sub-layer 233-2B. The first sub-layer 233-2A includes hydrogenated silicon and the second sub-layer 233-2B includes hydrogenated proto-crystalline silicon.

While only two photoelectric transformation layers are provided in the present embodiment, three or more photoelectric transformation layers can be also provided. Regarding a second photoelectric transformation layer or a third photoelectric transformation layer among three photoelectric transformation layers, which is far from a side of incident light, the second photoelectric transformation layer or the third photoelectric transformation layer can include a light absorbing layer including a first sub-layer and a second sub-layer. The first sub-layer includes hydrogenated silicon and the second sub-layer includes hydrogenated proto-crystalline silicon.

With respect to such photovoltaic devices according to the first and the second embodiments, a manufacturing method of the photovoltaic device will be described below in more detail.

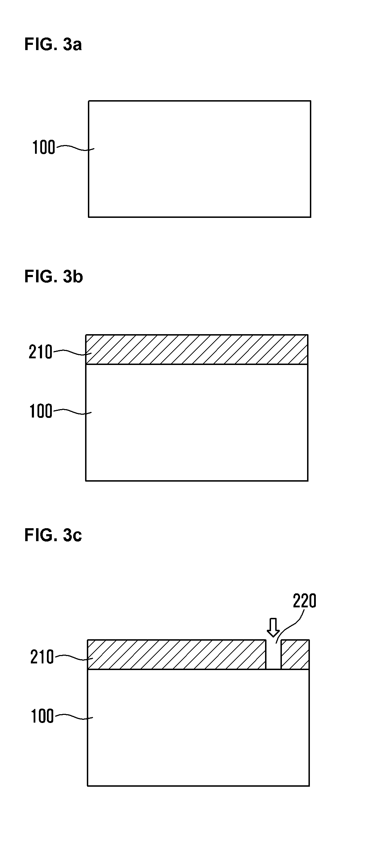

Figs. 3A to 3H show a manufacturing method of a photovoltaic device according to an embodiment of the present invention.

As shown in Fig. 3A, a substrate 100 is provided first. An insulating transparent substrate 100 can be used as the substrate 100.

As shown in Fig. 3B, a first electrode 210 is formed on the substrate 100. In the embodiment of the present invention, the first electrode 210 can be made by chemical vapor deposition (CVD) or be made of transparent conductive oxide (TCO) such as SnO₂ or ZnO.

As shown in Fig. 3C, a laser beam is irradiated onto the first electrode 210 or the substrate 100 so that the first electrode 210 is partially removed. As a result, a first separation groove 220 is formed. That is, since the separation groove 210 penetrates the first electrode 210, preventing adjacent first electrodes from being short-circuited.

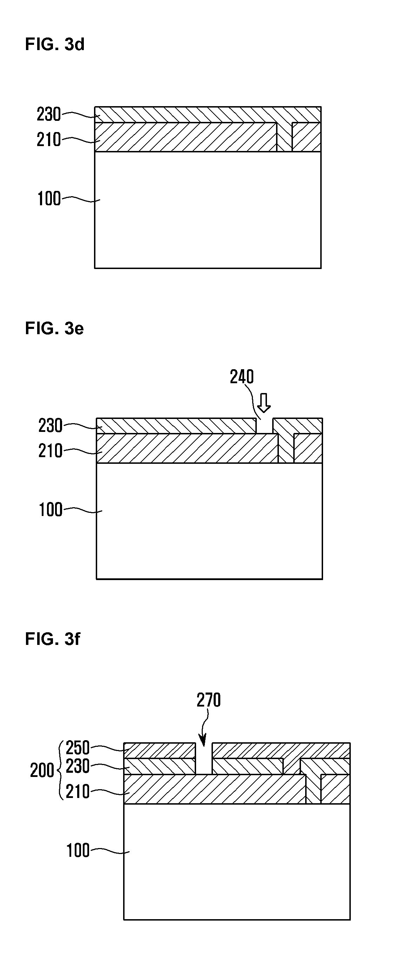

As shown in Fig. 3D, at least one photoelectric transformation layer 230 including a light absorbing layer is stacked by CVD in such a manner as to cover the first electrode 210 and the first separation groove 220. In this case, each photoelectric transformation layer 230 includes a p-type semiconductor layer, a light absorbing layer and an n-type semiconductor layer. In order to form the p-type semiconductor layer, source gas including silicon, for example, SiH₄ and source gas including group 3 elements, for example, B₂H₆ are mixed in a reaction chamber, and then the p-type semiconductor layer is formed by CVD. Then, the source gas including silicon is flown to the reaction chamber so that the light absorbing layer is formed on the p-type semiconductor layer by CVD. A method of manufacturing the light absorbing layer will be described later in detail. Finally, reaction gas including group 5 element, for example, PH₃ and source gas including silicon are mixed, and then the n-type semiconductor layer is stacked on an intrinsic semiconductor by CVD. Accordingly, the p-type semiconductor layer, the light absorbing layer and the n-type semiconductor layer are stacked on the first electrode 210 in order specified.

The light absorbing layer according to the embodiment of the present invention can be included in a single junction photovoltaic device including one photoelectric transformation layer 230 or in a multiple junction photovoltaic device including a plurality of photoelectric transformation layers.

As shown in Fig. 3E, a laser beam is irradiated from the air onto the substrate 100 or the photoelectric transformation layer 230 so that the photoelectric transformation layer 230 is partially removed. A second separation groove 240 is hereby formed in the photoelectric transformation layer 230.

As shown in Fig. 3F, the second electrode 250 is formed by CVD or sputtering process to cover the photoelectric transformation layer 230 and the second separation groove 240. A metal layer made of Al or Ag can be used as the second electrode 250.

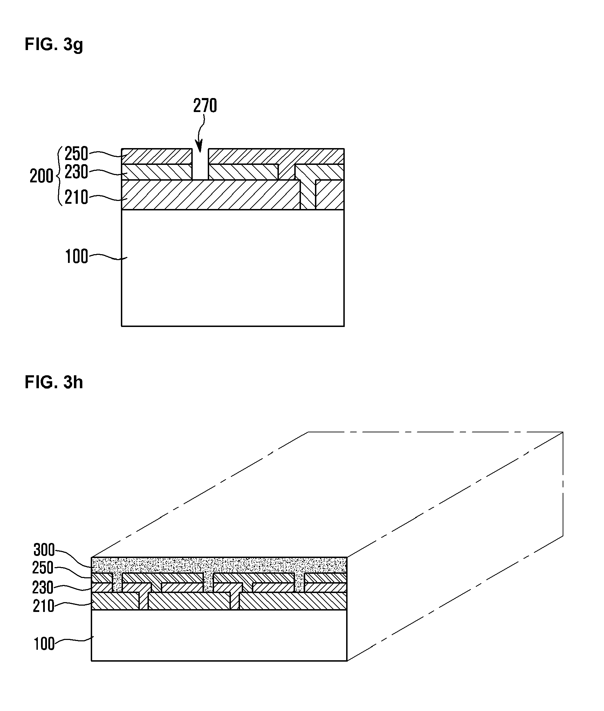

As shown in Fig. 3G, a laser beam is irradiated from the air onto the substrate 100 so that the photoelectric transformation layer 230 and the second electrode 250 are partially removed. As a result, a third separation groove 270 is formed in the photo voltaic layer 230 and the second electrode 250.

As shown in Fig. 3H, through lamination process, a protecting layer 300 covers partially or entirely a photovoltaic cell 200 including the photoelectric transformation layer 230, the first electrode 210 and the second electrode 250 so as to protect the photovoltaic cell 200. The protecting layer 300 can include ethylene Vinyl Acetate (EVA).

Through such a process, provided is the photoelectric transformation layer 200 having the protecting layer 300 formed thereon. A backsheet (not shown) can be made on the protecting layer.

In the next place, a manufacturing method of the light absorbing layer will be described in detail with reference to figures.

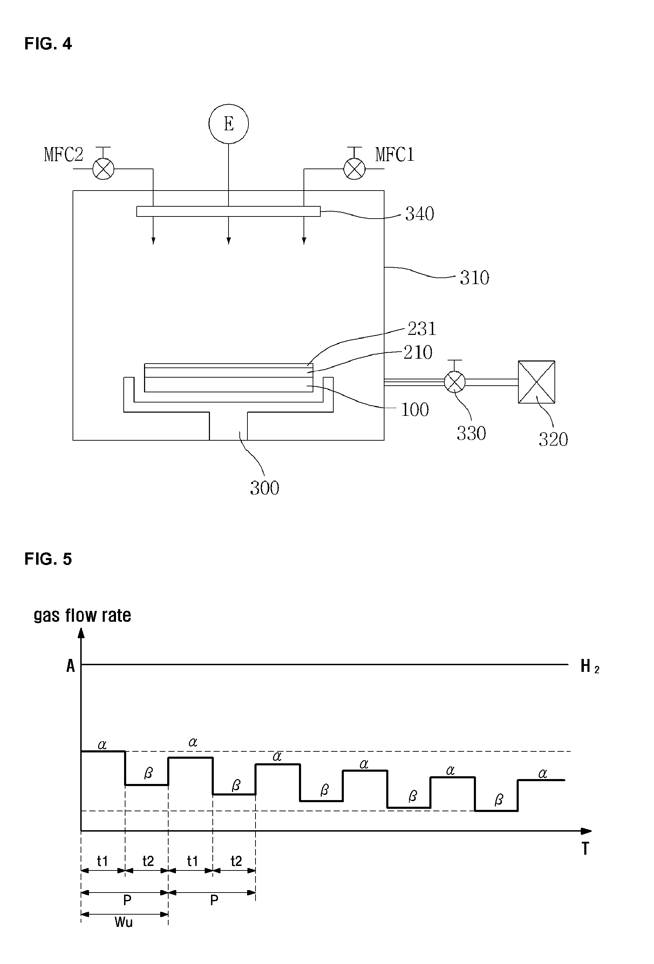

Fig. 4 shows a plasma-enhanced chemical vapor deposition apparatus for forming a light absorbing layer according to an embodiment of the present invention. As shown in Fig. 4, the first electrode 210 and the p-type semiconductor layer 231 are formed on the substrate 100. The substrate 100 is disposed on a plate 300 functioning as an electrode. A vacuum pump 320 operates in order to remove impurities in a chamber 310 before the light absorbing layer forming process. As a result, the impurities in the chamber 310 are removed through an angle valve 330 so that the inside of the chamber 310 is actually in a vacuum state.

When the inside of the chamber 310 is actually in a vacuum state, source gas such as hydrogen (H₂) and silane (SiH₄) is flown to the inside of the chamber 310 through mass flow controllers MFC1 and MFC2 and an electrode 340 having a nozzle formed therein. That is, the hydrogen is flown to the chamber through a first mass flow controller MFC1. The silane is flown to the chamber through a second mass flow controller MFC2. Here, the angle valve 330 is controlled to maintain the pressure of the chamber 310 constant. When the pressure of the chamber 310 is maintained constant, silicon powder caused by a vortex created in the chamber 310 can be prevented from being generated and deposition condition can be maintained constant. The hydrogen is flown to the chamber in order to dilute the silane and reduces Staebler-Wronski effect.

When the source gases are flown to the chamber and a voltage from an electric power source E is supplied to the electrode, an electric potential difference is generated between the electrode 340 and the plate 300. As a result, the source gas is in a plasma state, and the light absorbing layer is deposited on the p-type semiconductor layer 231. In this case, the flow rate of source gas of silane is controlled in accordance with a deposition time such that at least one sub-layer is formed on the p-type semiconductor layer.

Fig. 5 shows a variation of flow rate of source gas for forming a light absorbing layer according to an embodiment of the present invention.

A flow rate A of hydrogen is constant in accordance with the elapse of the deposition time T. A flow rate of the silane varies alternately within a range between a first flow rate value α and a second flow rate value β in accordance with the elapse of deposition time T. The first flow rate value α and the second flow rate value β are reduced in accordance with the elapse of deposition time T. Here, during one cycle P derived from a sum of a duration time of the first flow rate value α and a duration time of the second flow rate value β, the duration time t1 of the first flow rate value α and the duration time t2 of the second flow rate value β are constant in accordance with the elapse of deposition time T.

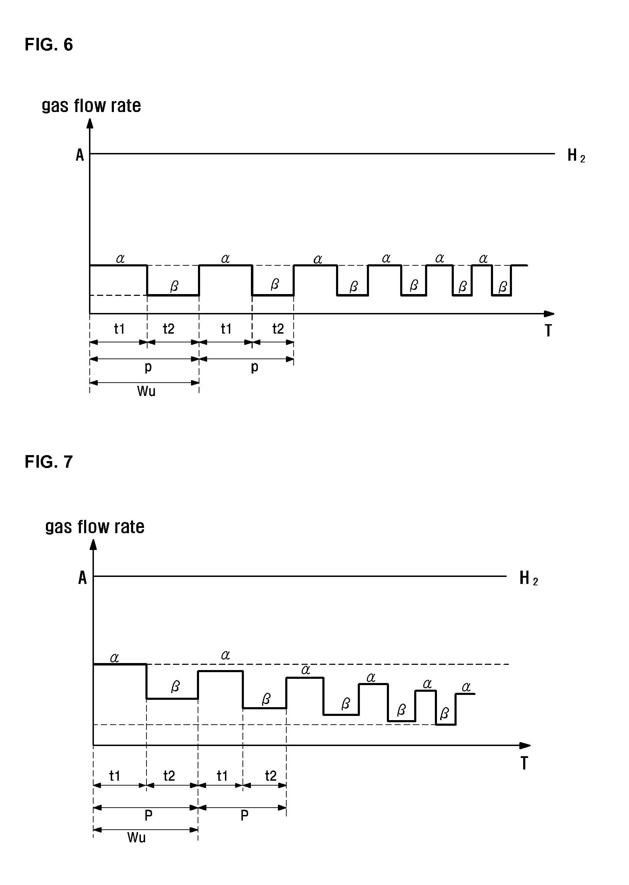

In the embodiment of the present invention, while hydrogen and silane can be supplied according to a graph of Fig. 5, hydrogen and silane can be also supplied according to a graph of Fig. 6.

Fig. 6 shows another variation of flow rate of source gas for forming a light absorbing layer according to an embodiment of the present invention.

As shown in Fig. 6, the flow rate A of hydrogen is constant in accordance with the deposition time T. The flow rate of silane varies alternately within a range between the first flow rate value α and the second flow rate value β in accordance with the elapse of deposition time T. During one cycle P derived from a sum of a duration time of the first flow rate value α and a duration time of the second flow rate value β the duration time t1 of the first flow rate value α and the duration time t2 of the second flow rate value β are reduced in accordance with the elapse of deposition time T. Here, the first flow rate value α and the second flow rate value β are constant in accordance with the elapse of deposition time T.

In the embodiment of the present invention, hydrogen and silane can be supplied according to a graph of Fig. 5.

Fig. 7 shows further another variation of flow rate of source gas for forming a light absorbing layer according to an embodiment of the present invention.

As shown in Fig. 7, the flow rate A of hydrogen is constant in accordance with the deposition time T. The flow rate of silane varies alternately within a range between the first flow rate value α and the second flow rate value β in accordance with the elapse of deposition time T. During one cycle P derived from a sum of a duration time of the first flow rate value α and a duration time of the second flow rate value β, the duration time t1 of the first flow rate value α and the duration time t2 of the second flow rate value β are reduced in accordance with the elapse of deposition time T. Here, the first flow rate value α and the second flow rate value β are reduced in accordance with the elapse of deposition time T.

As described in Figs. 5 to 7, in the embodiment of the present invention, the flow rate A of hydrogen is constant in accordance with the deposition time T. A ratio of the duration time t1 of the first flow rate value α to the duration time t2 of the second flow rate value β is also constant. As a result, a first sub-layer 233A and a second sub-layer 233B are formed, which have a certain thickness ratio therebetween. In this case, the flow rate of the silane decreases, varying alternately within a range between the first flow rate value α and the second flow rate value β in accordance with the elapse of deposition time T. This will be described later in detail.

As such, when the flow rate A of hydrogen is constant in accordance with the elapse of the deposition time T and the flow rate of silane varies alternately within a range between the first flow rate value α and the second flow rate value β in accordance with the elapse of deposition time T, a hydrogen dilution ratio varies. The hydrogen dilution ratio corresponds to a ratio of the flow rate of silane to the flow rate of hydrogen (that is, A/α, A/β). The first flow rate value α is greater than the second flow rate value β. Therefore, a hydrogen dilution ratio during a time period during which the silane with the first flow rate value α is supplied is less than a hydrogen dilution ratio during a time period during which the silane with the second flow rate value β is supplied.

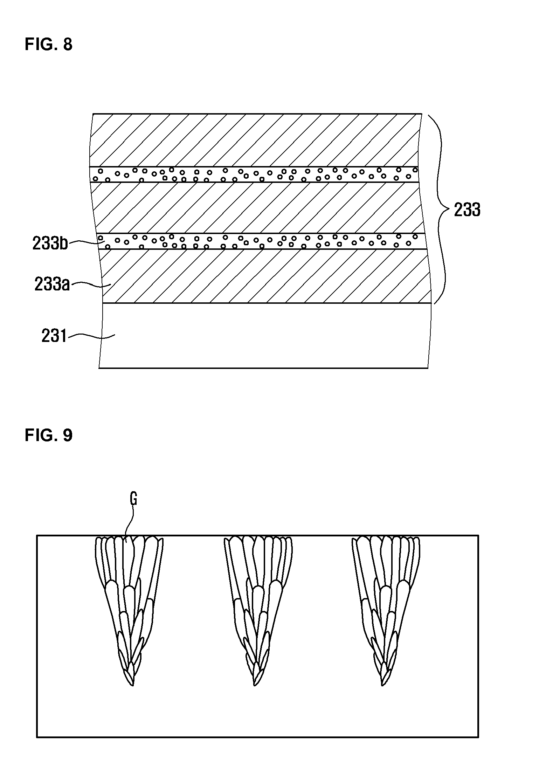

When a hydrogen dilution ratio varies as mentioned above, the light absorbing layer 233 including a plurality of the sub-layers 233A and 233B is formed on the p-type semiconductor layer 231 as shown in Fig. 8. The sub-layers 233A and 233B consist of hydrogenated proto-crystalline silicon sub-layer 233B (pc-Si:H) and hydrogenated amorphous silicon sub-layer 233A (a-Si:H). The hydrogenated proto-crystalline silicon sub-layer 233B (pc-Si:H) includes a crystalline silicon grain. The hydrogenated amorphous silicon sub-layer 233A (a-Si:H) includes amorphous silicon. The hydrogenated proto-crystalline silicon based sub-layer 233B is produced during the process of a phase change of the amorphous silicon progress to micro-crystalline silicon.

Hereinafter, the hydrogenated amorphous silicon based sub-layer is referred to as the first sub-layer 233A. The hydrogenated proto-crytalline silicon based sub-layer is referred to as the second sub-layer 233B.

In this case, when the hydrogen dilution ratio is low, the first sub-layer 233A which is rapidly deposited is formed. The first sub-layer 233A includes amorphous silicon. When the hydrogen dilution ratio is high, the second sub-layer 233B which is deposited slowly is formed. The second sub-layer 233B includes a crystalline silicon grain.

Accordingly, the first sub-layer 233A is formed during a time period during which the silane with the first flow rate value α is supplied. The second sub-layer 233B is formed during a time period during which the silane with the second flow rate value β is supplied.

As such, when the light absorbing layer 233 including a plurality of the sub-layers 233A and 233B is made, the degradation rate, i.e., a difference between an initial efficiency and a stabilization efficiency, is reduced. Accordingly, the photovoltaic device according to the embodiment of the present invention can have a high stabilization efficiency.

In other words, the first sub-layer 233A made of an amorphous silicon based material prevents columnar growth of the crystalline silicon grain of the second sub-layer 233B. As shown in Fig. 9, when the light absorbing layer is formed of only a proto-crystalline silicon layer unlike the embodiment of the present invention, the columnar growth of the crystalline silicon grain is accomplished. That is to say, as deposition is performed, the diameter of the crystalline silicon grain G is increased.

Such a columnar growth of the crystalline silicon grain increases not only a recombination rate of a carrier such as an electron hole or an electron, but also a time required for the efficiency of the photovoltaic device to reach the stabilization efficiency by crystalline silicon grains having non-uniform diameter. The stabilization efficiency of the photovoltaic device is also reduced.

However, in the case of the light absorbing layer 233 including a plurality of sub-layers 233A and 233B in the embodiment of the present invention, since a short-range-order (SRO) and a medium-range-order (MRO) are improved, the degradation of the light absorbing layer 233 is rapid and the stabilization efficiency is increased. The amorphous silicon of the first sub-layer 233A prevents columnar growth of the crystalline silicon grain and has a uniform diameter, so that a time required for the efficiency of the photovoltaic device to reach the stabilization efficiency is reduced and a high stabilization efficiency is obtained.

The crystalline silicon grains of the second sub-layer 233B are covered with amorphous silicon based material and separated from each other. The separated crystalline silicon grain performs a core function of radioactive recombination of a part of captured carriers, preventing photocreation of dangling bond. This reduces non-radioactive recombination of the amorphous silicon based material, which surrounds the crystalline silicon grains, of the second sub-layer 233B.

Meanwhile, since the silane cyclically increases and decreases, the more the deposition time T increases, the more the silane remaining in the chamber 310 can increase. Therefore, the hydrogen dilution ratio is reduced and the thicknesses of the first and the second sub-layers 233A and 233B are not maintained constant. It is also difficult to form the crystalline silicon grain of the second sub-layer 233B. As a result, as the flow rate of the silane varies alternately within a range between the first flow rate value α and the second flow rate value β, the properties of the light absorbing layer 233 can be degraded.

In the embodiment of the present invention, the first flow rate value α and the second flow rate value β of the silane is reduced in accordance with the elapse of the deposition time T, offsetting the hydrogen dilution ratio's variation caused by the remaining silane. The light absorbing layer 233 can be hereby prevented from being degraded.

In the meantime, as described above, the flow rate of hydrogen is constant and the flow rate of silane varies so as to cause the hydrogen dilution ratio to be varied because the flow rate of hydrogen supplied to the inside of the chamber 310 is greater than that of the silane supplied to the inside of the chamber 310, so that it is relatively more difficult to control the flow rate of hydrogen than to control the flow rate of the silane. Therefore, if the flow rate of hydrogen is constant, it is easier to control the hydrogen dilution ratio. In particular, if the flow rate of hydrogen flown to the chamber is constant, a vortex, which is caused by the variation of the flow rate of hydrogen, within the chamber 310 is reduced, improving a film characteristic of the light absorbing layer 233.

If the flow rate of hydrogen varies within a range between 0 and a certain value so as to cause the hydrogen dilution ratio to be varied, during a period of time during which the flow rate of hydrogen is equal to 0 as the flow rate of hydrogen varies cyclically, that is, a period of time during which hydrogen is not flown from the outside to the chamber, the hydrogen which remains in the chamber 310 increases in accordance with the deposition time T, increasing crystallines of the sub-layers. As a result, it is difficult to form sub-layers having a uniform crystalline diameter and a uniform thickness.

On the other hand, in the embodiment of the present invention, since the flow rate of hydrogen is constant and the flow rate of the silane is caused to vary cyclically, an amount of hydrogen in the chamber 310 is maintained constant, making it easier to form the sub-layers 233A and 233B having a uniform crystalline diameter and a uniform thickness.

As described above, in the embodiment of the present invention, plasma-enhanced chemical vapor deposition method is used instead of photo-CVD. The photo-CVD is not suitable for manufacturing a large area photovoltaic device. Also, as deposition is performed, a thin film is deposited on a quartz window of a photo-CVD device, reducing UV light transmitting the quartz window.

For this reason, a deposition rate is gradually reduced and the thicknesses of the first sub-layer 233A and the second sub-layer 233B are gradually reduced. Contrarily, the plasma-enhanced chemical vapor deposition method can solve the defects of the photo-CVD.

As mentioned above, the crystalline silicon grain having a uniform diameter reduces a time required for the efficiency of the photovoltaic device to reach the stabilization efficiency and improves the stabilization efficiency.

To this end, in the embodiment of the present invention, the hydrogen dilution ratio of the chamber 310 is maintained constant while the second sub-layer 233B of the light absorbing layer 233 is repeatedly deposited.

That is, as shown in Fig. 5, the flow rate of hydrogen is constant and a ratio of a time period for supplying the silane with the first flow rate value α to a time period for supplying the silane with the second flow rate value β is constant. The first and the second flow rate values α and β are reduced in accordance with the deposition time in order to offset the remaining silane. Accordingly, the hydrogen dilution ratio within the chamber 310 is maintained constant for the purpose of forming a plurality of the second sub-layers 233B.

As shown in Fig. 6, the flow rate of hydrogen is constant and the first and the second flow rate values α and β of silane are constant. Time periods for supplying the silane with the first and the second flow rate values α and β are reduced in accordance with the deposition time in order to offset the remaining silane. Accordingly, an actual hydrogen dilution ratio within the chamber 310 is maintained constant for the purpose of forming a plurality of the second sub-layers 233B.

For this reason, since the actual hydrogen dilution ratio within the chamber 310 is maintained constant, a diameter of the crystalline silicon grain of the sub-layer 233B can be maintained constant.

In the embodiment of the present invention, a thickness of the first sub-layer 233A made of amorphous silicon can be equal to or more than 10 nm. A sum of the thickness of the first sub-layer 233A and the thickness of the second sub-layer 233B, which are formed during one cycle P, can be equal to or less than 50 nm. It is more desirable that the sum is less than 30 nm.

Here, during more than three cycles P, the thickness of the light absorbing layer 233 including the first and the second sub-layers 233A and 233B can be equal to or more than 150 nm and equal to or less than 350 nm.

For example, if a sum of the thickness of the first sub-layer 233A and the thickness of the second sub-layer 233B , which are formed during one cycle P, is 50 nm, a light absorbing layer 233 can be formed, which has a thickness of 150 nm in three cycles and includes three first sub-layers 233A and three second sub-layers 233B.

During a time period less than three cycles, a light absorbing layer 233 having a thickness equal to or more than 150 nm and equal to or less than 350 nm is formed. The thickness of the first sub-layer 233A made of amorphous silicon layers is excessively increased. As a result, recombinations in the amorphous silicon layer are increased, degrading a stabilization efficiency.

A diameter of a crystalline silicon grain can be equal to or more than 3 nm and equal to or less than 10 nm. It is difficult to form a crystalline silicon grain having a diameter less than 3 nm and a degradation rate reduction effect of a solar cell is reduced. If the crystalline silicon grain has a diameter greater than 10nm, the volume of grain boundary in the circumference of the crystalline silicon grain is excessively increased. As a result, the crystalline silicon grain is also increasingly recombined with each other, thereby reducing the efficiency.

An optical band gap of such a light absorbing layer can be equal to or more than 1.85 eV and equal to or less than 2.0 eV. To form the crystalline silicon grain generates a quantum effect caused by quantum dots. The light absorbing layer 233 according to the embodiment of the present invention has hereby a large optical band gap which is equal to or more than 1.85 eV and equal to or less than 2.0 eV. When a light absorbing layer having an optical band gap equal to or more than 1.85 eV is used in a top cell of a single junction photovoltaic device or a multiple junction tandem photovoltaic device, the light absorbing layer can absorb much light with a short wavelength having a high energy density. If the optical band gap is greater than 2.0 eV, the light absorbing layer 233 including the plurality of sub-layers 233A and 233B is difficult to form and absorption of light is reduced. Therefore, the efficiency can be reduced by reduction of a short-circuit current. The top cell corresponds to a photoelectric transformation layer on which light is first incident among photoelectric transformation layers that the multiple junction tandem photovoltaic device includes.

An average hydrogen content of the light absorbing layer 233 including a plurality of the sub-layers 233A and 233B can be equal to or more than 15 atomic % and equal to or less than 25 atomic %. If the average hydrogen content of the light absorbing layer 233 is less than 15 atomic %, the size and density of the quantum dot are reduced, and then the optical band gap of the light absorbing layer 233 can be reduced and the degradation rate of the light absorbing layer 233 can be increased. If the average hydrogen content of the light absorbing layer 233 is greater than 25 atomic %, the diameter of the crystalline silicon grain is excessively increased so that a volume of unstable amorphous silicon is also increased. Accordingly, the degradation rate can be increased.

A warming-up period WU can be provided before starting to deposit the light absorbing layer 233. In other words, as shown in Figs. 5 to 7, a voltage is not supplied to the electrode 340 of the chamber 310 during a period of time more than a first cycle P for supplying silane with the first flow rate value α and the second flow rate value β. The period of time corresponds to the warming-up period.

Because a voltage is not supplied to the chamber during the warming-up period, plasma is not generated. Since the chamber 310 is in a vacuum state, a condition inside the chamber 310 may not satisfy the deposition condition of the light absorbing layer 233 even though source gas for forming the light absorbing layer 233 is supplied to the chamber.

Therefore, in the case where a deposition is not performed due to no generation of plasma during the warming-up period WU and where a deposition is performed by generation of plasma when a condition inside the chamber 310 satisfies the deposition condition of the light absorbing layer 233 after the warming-up period WU, the light absorbing layer 233 can be stably formed.

The foregoing embodiments and advantages are merely exemplary and are not to be construed as limiting the present invention. The present teaching can be readily applied to other types of apparatuses. The description of the foregoing embodiments is intended to be illustrative, and not to limit the scope of the claims. Many alternatives, modifications, and variations will be apparent to those skilled in the art. In the claims, means-plus-function clauses are intended to cover the structures described herein as performing the recited function and not only structural equivalents but also equivalent structures. Moreover, unless the term "means" is explicitly recited in a limitation of the claims, such limitation is not intended to be interpreted under 35 USC 112(6).

## Claims

1. A photovoltaic device comprising:
a substrate 100;
a first electrode disposed 210 on the substrate 100;
a plurality of photoelectric transformation layers 230-1 and 230-2 disposed on the first electrode, the photoelectric transformation layer comprising light absorbing layers 233-1 and 233-2; and
a second electrode 250 disposed on a plurality of the photoelectric transformation layers 230-1 and 230-2;
wherein the light absorbing layer 233-2 comprised in at least one photoelectric transformation layer 230-2 of a plurality of the photoelectric transformation layers 230-1 and 230-2 comprises a first sub-layer 233-2A and a second sub-layer 233-2B, each of which comprises hydrogenated amorphous silicon and hydrogenated proto-crystalline silicon respectively, and
wherein a thickness of the first sub-layer 233-2A is actually the same as a thickness of the second sub-layer 233-2B.

2. The photovoltaic device of claim 1, wherein a thickness of the light absorbing layer is equal to or more than 150 nm and equal to or less than 350 nm.

3. The photovoltaic device of claim 1, wherein an average hydrogen content of the light absorbing layer is equal to or more than 15 atomic % and equal to or less than 25 atomic %.

4. A method of manufacturing a photovoltaic device, the method comprising:
forming a first electrode 210 on a substrate 100;
forming at least one photoelectric transformation layer 230 on the first electrode 210 in a chamber 310, the photoelectric transformation layer comprising a light absorbing layer 233;
forming a second electrode 250 on the photoelectric transformation layer 230;
wherein silane and hydrogen with a certain flow rate are supplied to the chamber 310 while the light absorbing layer 233 is formed, and
wherein a flow rate of the silane varies alternately within a range between a first flow rate value α and a second flow rate value β in accordance with the elapse of a deposition time T, and
wherein the first flow rate value α and the second flow rate value β are reduced in accordance with the elapse of the deposition time T.

5. A method of manufacturing a photovoltaic device, the method comprising:
forming a first electrode 210 on a substrate 100;
forming at least one photoelectric transformation layer 230 on the first electrode 210 in a chamber 310, the photoelectric transformation layer comprising a light absorbing layer 233;
forming a second electrode 250 on the photoelectric transformation layer 230;
wherein silane and hydrogen with a certain flow rate are supplied to the chamber 310 while the light absorbing layer 233 is formed, and
wherein a flow rate of the silane varies alternately within a range between a first flow rate value and a second flow rate value in accordance with the elapse of a deposition time T, and
wherein a duration time of the first flow rate value and a duration time of the second flow rate value are reduced in accordance with the elapse of the deposition time T.

6. A method of manufacturing a photovoltaic device, the method comprising:
forming a first electrode 210 on a substrate 100;
forming at least one photoelectric transformation layer 230 on the first electrode 210 in a chamber 310, the photoelectric transformation layer comprising a light absorbing layer 233;
forming a second electrode 250 on the photoelectric transformation layer 230;
wherein silane and hydrogen with a certain flow rate are supplied to the chamber 310 while the light absorbing layer 233 is formed, and
wherein a flow rate of the silane varies alternately within a range between a first flow rate value α and a second flow rate value β in accordance with the elapse of a deposition time T, and
wherein a duration time t1 of the first flow rate value α and a duration time t2 of the second flow rate value β are reduced in accordance with the elapse of the deposition time T, and
wherein the first flow rate value α and the second flow rate value β are reduced in accordance with the elapse of the deposition time T.

7. The method of claim 5, wherein the first flow rate value and the second flow rate value are constant in accordance with the elapse of the deposition time.

8. The method of claims 4 to 6, wherein the first flow rate value is greater than the second flow rate value, and wherein a sub-layer of the light absorbing layer is formed while the first flow rate value is supplied, the sub-layer being made of amorphous silicon, and wherein a sub-layer of the light absorbing layer is formed while the second flow rate value is supplied, the sub-layer being made of a crystalline silicon grain.

9. The method of claims 4 to 6, wherein a thickness of the light absorbing layer is equal to or more than 150 nm and equal to or less than 350 nm.

10. The method of claims 4 to 6, wherein the first flow rate value is greater than the second flow rate value, and wherein the light absorbing layer comprises a first sub-layer and a second sub-layer, each of which is made of amorphous silicon while the first flow rate value is supplied and is made of a crystalline silicon grain, respectively, and wherein a thickness of the first sub-layer is equal to or more than 10 nm.

11. The method of claims 4 to 6, wherein the first flow rate value is greater than the second flow rate value, and wherein the light absorbing layer comprises a first sub-layer and a second sub-layer, each of which is made of amorphous silicon while the first flow rate value is supplied and is made of a crystalline silicon grain, respectively, and wherein a diameter of the crystalline silicon grain is equal to or more than 3nm and equal to or less than 10 nm.

12. The method of claims 4 to 6, wherein the first flow rate value is greater than the second flow rate value, and wherein the light absorbing layer comprises a first sub-layer and a second sub-layer, each of which is made of amorphous silicon while the first flow rate value is supplied and is made of a crystalline silicon grain, respectively, and wherein thicknesses of the first sub-layer and the second sub-layer which are formed during one cycle are equal to or less than 50 nm.

13. The method of claims 4 to 6, an optical band gap of the light absorbing layer is equal to or more than 1.85 eV and equal to or less than 2.0 eV.

14. The method of claims 4 to 6, wherein a voltage is not supplied to the electrode of the chamber during a period of time more than a first cycle for supplying silane with the first flow rate value and the second flow rate value.

15. The method of claims 4 to 6, wherein a pressure of the chamber is constant.

16. The method of claims 4 to 6, wherein an average hydrogen content of the light absorbing layer is equal to or more than 15 atomic % and equal to or less than 25 atomic %.
